# EUROPÄISCHE PATENTANMELDUNG

(11) **EP 0 655 832 A2**
(43) Veröffentlichungstag der Anmeldung: **31.05.1995**
(21) Anmeldenummer: 94113173.2
(22) Anmeldetag: 24.08.1994
(51) Int. Cl.: H03G 3/30, H03G 3/20, H03G 11/00

(54) **Schaltungsanordnung zur Begrenzung von Verzerrungen von Audiosignalen**

(30) Priorität: 25.11.1993 DE 4340167
(71) Anmelder: Blaupunkt-Werke GmbH, D-31132 Hildesheim (DE)
(72) Erfinder: Reger, Michael, Dipl.-Ing., D-31079 Sibbesse (DE); Scholz, Hans-Günther, D-31137 Hildesheim (DE)

(57) **Zusammenfassung**

Bei einer Schaltungsanordnung zur Begrenzung von bei der Wiedergabe in einem Rundfunkempfänger mit mindestens einer Endstufe entstehenden Verzerrungen von Audiosignalen ist an der Endstufe ein Signal abnehmbar, das einen vorgegebenen Aussteuerungsgrad kennzeichnet. Das über ein Integrationsglied geleitete Signal bildet eine den Klirrfaktor beschreibende Spannung und über eine vorgegebene Kennlinie eine Stellgröße, die einem Stellglied für die Verstärkung der Audiosignale zugeleitet wird.

## Beschreibung

Die Erfindung betrifft eine Schaltungsanordnung zur Begrenzung von bei der Wiedergabe in einem Rundfunkempfänger mit mindestens einer Endstufe entstehenden Verzerrungen von Audiosignalen.

Insbesondere in Autoradios wird häufig die Lautstärke derart hoch eingestellt, daß die Endstufen übersteuert werden und somit ein hoher Klirrfaktor entsteht. Dieses kann beispielsweise auch auftreten, wenn von einem Sender mit relativ niedrigem Frequenzhub auf einen Sender mit hohem Frequenzhub umgeschaltet wird, nachdem zuvor die Lautstärke noch auf einen bezüglich des Klirrfaktors annehmbaren Wert eingestellt war.

Aufgabe der Erfindung ist es, eine möglichst verzerrungfreie Wiedergabe der Audiosignale auch bei hohen eingestellten Lautstärken und Frequenzhüben sicherzustellen.

Diese Aufgabe wird erfindungsgemäß dadurch gelöst, daß an der Endstufe ein Signal abnehmbar ist, das einen vorgegebenen Aussteuerungsgrad kennzeichnet, daß das über ein Integrationsglied geleitete Signal eine den Klirrfaktor beschreibende Spannung bildet und über eine vorgegebene Kennlinie eine Stellgröße bildet, die einem Stellglied für die Verstärkung der Audiosignale zugeleitet wird.

Die Erfindung ermöglicht eine Begrenzung der Verzerrungen mit geringem technischen Aufwand. So sind beispielsweise Stellglieder für die Verstärkung der Audiosignale in vielen Rundfunkempfängern ohnehin vorhanden. Auch die Ableitung des den vorgegebenen Aussteuerungsgrad kennzeichnenden Signals ist bei auf dem Markt erhältlichen integrierten Endstufen ebenfalls möglich.

Vorzugsweise ist bei der erfindungsgemäßen Schaltungsanordnung vorgesehen, daß der vorgegebene Aussteuerungsgrad einstellbar ist. Damit ist auch die Grenze der Verzerrungen einstellbar, was vorzugsweise vom Hersteller des Rundfunkempfängers erfolgt, um die Eigenschaften des Rundfunkempfängers an die jeweiligen Erfordernisse anzupassen, beispielsweise Autoradios an die Vorstellungen der Erstausrüster (Kfz-Hersteller).

Eine vorteilhafte Ausgestaltung der erfindungsgemäßen Schaltungsanordnung besteht darin, daß zur Bildung der Stellgröße ein Mikrocomputer vorgesehen ist mit einem Analogsignaleingang, dem das über das Integrationsglied mit unterschiedlicher Lade- bzw. Entladezeit geleitete Signal zuführbar ist, daß die vorgegebene Kennlinie als Tabelle im Mikrocomputer abgelegt ist und daß die Stellgröße vom Mikrocomputer derart gebildet wird, daß bei einem Überschreiten eines Grenzwertes durch die den Klirrfaktor beschreibende Spannung zunächst eine schnelle Verringerung und darauf folgend eine langsame Erhöhung der Verstärkung vorgenommen wird. Ein geeignetes Programm im Mikrocomputer sowie die Tabelle können in einfacher Weise an die jeweiligen Erfordernisse angepaßt werden.

Gemäß einer Weiterbildung der erfindungsgemäßen Schaltungsanordnung ist vorgesehen, daß das Stellglied aus zwei digital ansteuerbaren Stellgliedern besteht, wobei ein erstes an sich bekanntes Stellglied eine gröbere Quantisierung als ein zweites Stellglied aufweist und daß das erste Stellglied mit höherwertigen Binärstellen und das zweite Stellglied mit geringwertigen Binärstellen des die Stellgröße darstellenden Ausgangssignals des Mikrocomputers gesteuert wird.

Das erste Stellglied kann dabei mit Hilfe eines im Handel erhältlichen integrierten Schaltkreises realisiert werden, der jedoch eine relativ grobe Quantisierung aufweist, bei welcher Knackgeräusche beim Umschalten der Verstärkung von einer auf die folgende Stufe hörbar sind. Um die grobe Quantisierung mit feineren Stufen zu überbrücken, ist das zweite Stellglied vorgesehen, das lediglich einige wenige Stufen aufzuweisen braucht. Vorzugsweise ist dabei vorgesehen, daß die Quantisierung des ersten Stellgliedes in 1,25-dB-Schritten und die Quantisierung des zweiten Stellgliedes in 0,3-dB-Schritten erfolgt.

Ausführungsbeispiele der Erfindung sind in der Zeichnung anhand mehrerer Figuren dargestellt und in der nachfolgenden Beschreibung näher erläutert. Es zeigt:
- Fig. 1: ein erstes Ausführungsbeispiel,
- Fig. 2: ein zweites Ausführungsbeispiel, jeweils als Blockschaltbild,
- Fig. 3: zeigt die Abhängigkeit der den Klirrfaktor beschreibenden Spannung vom Klirrfaktor und
- Fig. 4: eine im Mikrocomputer als Tabelle gespeicherte Kennlinie.

Gleiche Teile sind in den Figuren mit gleichen Bezugszeichen versehen. Der Übersichtlichkeit halber wurden bei den Ausführungsbeispielen jeweils nur ein Stellglied für die Verstärkung und eine Endstufe dargestellt. Die Anwendung der erfindungsgemäßen Schaltungsanordnung erfolgt jedoch im allgemeinen im Zusammenhang mit einer Stereo-Wiedergabe.

Bei 1 werden dererfindungsgemäßen Schaltungsanordnung Audiosignale zugeführt, die beispielsweise durch Demodulation eines von einem Empfänger empfangenen Signals oder durch Wiedergabe von einem Aufzeichnungsträger erzeugt werden. Die Verstärkung der Audiosignale ist mit Hilfe eines Lautstärkestellers 2, welchem die Stellgröße digital zugeführt wird, einstellbar. Der Lautstärkesteller dient außer zur Herabsetzung der Verstärkung der Audiosignale im Sinne der Erfindung auch zur Einstellung der Lautstärke und zusammen mit nicht dargestellten frequenzabhängigen Gliedern zur Höhen- und Tiefeneinstellung. Ein hierzu geeigneter integrierter Schaltkreis ist unter der Typenbezeichnung TDA 7316 erhältlich. Als Endstufe kann ein integrierter Schaltkreis mit der Typenbezeichnung TDA 5560 verwendet werden.

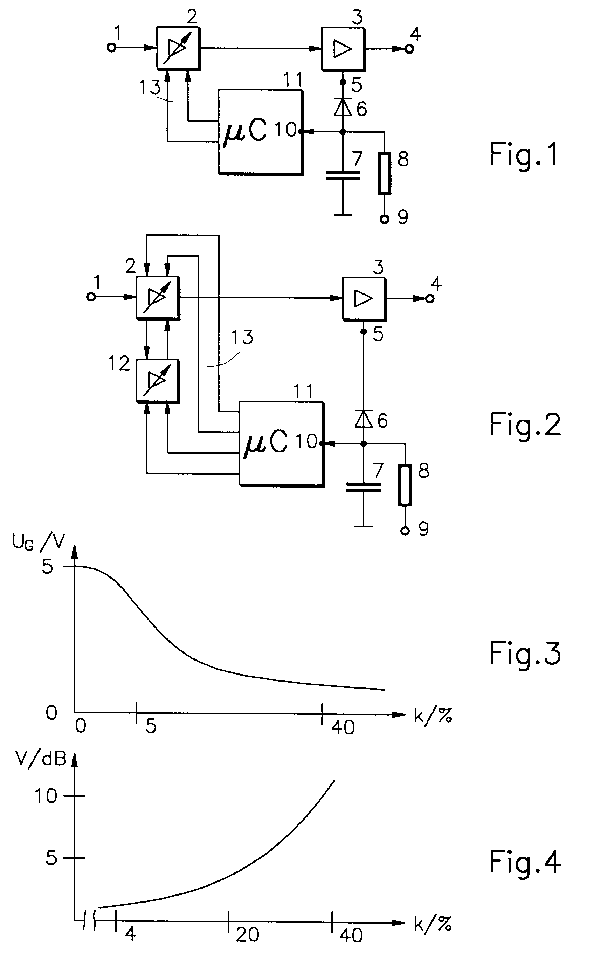

Über eine Endstufe 3 gelangen die Audiosignale zum Ausgang 4, an den ein Lautsprecher angeschlossen wird. Die Endstufe 3 ist mit einem weiteren Ausgang 5 versehen, an welchem ein binäres Signal abnehmbar ist, dessen jeweiliger Pegel davon abhängig ist, ob das Ausgangssignal der Endstufe 3 über oder unterhalb einer vorgegebenen Aussteuerungsgrenze liegt. Dieses Signal wird über eine Diode 6 einem Kondensator 7 zugeleitet, der außerdem über einen Widerstand 8 mit einem Punkt 9 konstanter Spannung verbunden ist. Mit der als Tiefpaß wirksamen Kombination des Kondensators 7 mit dem Widerstand 8 und der Diode 6 erfolgt die Ableitung einer den Klirrfaktor beschreibenden Spannung. Diese hat bei einem realisierten Ausführungsbeispiel die in Fig. 3 dargestellte Abhängigkeit vom Klirrfaktor k und wird einem Eingang 10 eines Mikrocomputers 11 zugeführt. Der Eingang 10 ist für Analogsignale ausgerichtet, die mit Hilfe eines nicht dargestellten Analog/Digital-Wandlers im Mikrocomputer 11 in digitale Signale umgewandelt werden.

An der Höhe der Spannung U_{G} erkennt der Mikrocomputer die Höhe des Klirrfaktors. Aus einer Tabelle, die als Kurve in Fig. 4 dargestellt ist, wird die benötigte Dämpfung entnommen, damit im Mikrocomputer die richtige Sprungweite ermittelt werden kann. Aus Fig. 4 ergibt sich, daß bei sehr großen Klirrfaktoren eine Reduzierung der Verstärkung in größeren Schritten vorgenommen wird als bei relativ kleinen Klirrfaktoren. Die Stellgröße wird vom Mikrocomputer 11 zum Lautstärkesteller 2 durch einen I²C-Bus 13, der von zwei Leitungen gebildet wird, übertragen.

Das Programm im Mikrocomputer ist derart ausgeführt, daß eine schnelle Verminderung der Verstärkung durchgeführt wird, wenn der Klirrfaktor eine als zulässig angesehene Grenze überschreitet. Ein anschließendes Heranführen an den Sollwert erfolgt demgegenüber langsam.

Der oben erwähnte integrierte Lautstärkesteller weist Lautstärkestufen von 1,25dB auf. Bei der somit schrittweise sich erhöhenden oder vermindernden Lautstärke sind Knackgeräusche nicht auszuschließen. Außerdem ändert sich im Bereich größerer Aussteuerungen der Endstufe der Klirrfaktor bereits sehr stark, wenn die Verstärkung um 1,25dB geändert wird. Es ist deshalb bei dem Ausführungsbeispiel nach Fig. 2 eine feinere Abstufung der Verstärkungseinstellung vorgesehen. Dazu wird der Lautstärkesteller 2 durch einen weiteren Lautstärkesteller 12 ergänzt, dessen Amplitudenübertragungsmaß in vier Schritten um jeweils 0,3dB verstellbar ist. Dem weiteren Lautstärkesteller 12 wird vom Mikrocomputer 11 als Stellgröße ein Zwei-Bit-Signal zugeführt.

## Patentansprüche

1. Schaltungsanordnung zur Begrenzung von bei der Wiedergabe in einem Rundfunkempfänger mit mindestens einer Endstufe entstehenden Verzerrungen von Audiosignalen, dadurch gekennzeichnet, daß an der Endstufe (3) ein Signal abnehmbar ist, das einen vorgegebenen Aussteuerungsgrad kennzeichnet, daß das über ein Integrationsglied (6, 7, 8) geleitete Signal eine den Klirrfaktor beschreibende Spannung bildet und über eine vorgegebene Kennlinie eine Stellgröße bildet, die einem Stellglied (2) für die Verstärkung der Audiosignale zugeleitet wird.

2. Schaltungsanordnung nach Anspruch 1, dadurch gekennzeichnet, daß der vorgegebene Aussteuerungsgrad einstellbar ist.

3. Schaltungsanordnung nach einem der Ansprüche 1 oder 2, dadurch gekennzeichnet, daß zur Bildung der Stellgröße ein Mikrocomputer (11) vorgesehen ist mit einem Analogsignaleingang, dem das über das Integrationsglied (6, 7, 8) geleitete Signal zuführbar ist, daß die vorgegebene Kennlinie als Tabelle im Mikrocomputer (11) abgelegt ist und daß die Stellgröße vom Mikrocomputer (11) derart gebildet wird, daß bei einem Überschreiten eines Grenzwertes durch die den Klirrfaktor beschreibende Spannung zunächst eine schnelle Verringerung und darauf folgend eine langsame Erhöhung der Verstärkung vorgenommen wird.

4. Schaltungsanordnung nach Anspruch 3, dadurch gekennzeichnet, daß das Stellglied aus zwei digital ansteuerbaren Stellgliedern (2, 12) besteht, wobei ein erstes an sich bekanntes Stellglied (2) eine gröbere Quantisierung als ein zweites Stellglied (12) aufweist und daß das erste Stellglied (2) mit höherwertigen Binärstellen und das zweite Stellglied (12) mit geringwertigen Binärstellen des die Stellgröße darstellenden Ausgangssignals des Mikrocomputers (11) gesteuert wird.

5. Schaltungsanordnung nach Anspruch 4, dadurch gekennzeichnet, daß die Quantisierung des ersten Stellgliedes (2) in 1,25-dB-Schritten und die Quantisierung des zweiten Stellgliedes (12) in 0,3-dB-Schritten erfolgt.
